Europäisches Patentamt

European Patent Office

Office européen des brevets

(11) Publication number: **0 309 828**
**A2**

(12) **EUROPEAN PATENT APPLICATION**

(21) Application number: 88115209.4

(51) Int. Cl.4: **H01L 29/08**

(22) Date of filing: 16.09.88

(30) Priority: 02.10.87 IT 2213087

(43) Date of publication of application:
05.04.89 Bulletin 89/14

(84) Designated Contracting States:
**DE FR GB NL SE**

(71) Applicant: SGS-THOMSON
MICROELECTRONICS S.r.L.
Via C. Olivetti, 2
I-20041 Agrate Brianza Milan(IT)

(72) Inventor: **Crisenza, Giuseppe Paolo**
Via 11 Febbraio, 7/e
I-20056 Trezzo d'Adda Milan(IT)
Inventor: **Fontana, Gabriella**
Via don Tentori, 9
I-20059 Ruginello di Vimercate Milan(IT)
Inventor: **Picco Paolo**
Via Carlo Alberto, 39
I-20052 Monza Milan(IT)

(74) Representative: **Perani, Aurelio et al**
c/o JACOBACCI-CASETTA & PERANI 7, Via
Visconti di Modrone
I-20122 Milano(IT)

(54) **An electronic semiconductor device, in particular a silicon-gate field-effect MOS transistor, for high input voltages.**

(57) An electronic semiconductor device (1), in particular a silicon-gate field-effect MOS transistor obtained from a C MOS process and adapted for high input voltages, comprises a so-called Well pocket (3) having opposite doping from that of the semiconductor substrate (2) and inside which there are formed the source (4) and drain (5) zones of the transistor, as well as a layer (5a) with opposite doping from that of the Well pocket (3) and forming a side extension of the transistor drain (5) zone and being self-aligned to the gate oxide (6a) and covered with a layer of an isolating oxide (10). That layer (5a) is doped at a lower dopant concentration than that of the drain (5) zone, and the device (1) so made can also operate at significantly higher voltages than those applicable to other components of a circuit to which it is integrated.

Fig.1

This invention relates to an electronic semiconductor device, in particular a silicon-gate field-effect MOS transistor for high input voltages, and as formed by a C MOS process, of a type comprising a semiconductor silicon substrate formed with two zones with like doping intended to provide the source and drain electrodes for said transistor and to delimit a channel region overlaid by an oxide isolating layer, commonly referred to as gate oxide, covered by a conductive layer intended to provide the gate electrode for said transistor.

As is known, electronic semiconductor devices forming the so-called integrated circuit are powered with low voltages, on the order of a few volts.

Such integrated circuits are sometimes intended to control electrical apparatus operating on input voltages which far exceed those bearable by the integrated circuit itself.

Thus, where a control integrated circuit is to be incorporated to an electrical apparatus, structurally independent electric supply circuits, or alternatively voltage regulating interface circuits must be provided between the electric input to said apparatus and the control integrated circuit. As a result, the cost, as well as the design and manufacturing complexity, of such electrical apparatus are aggravated as a matter of course.

To obviate such a drawback, the prior art has also proposed of using electronic semiconductor devices, in particular devices which are compatible with the manufacturing technologies for C MOS (Complementary Metal Oxide Semiconductor) type circuits capable of accepting high input voltages, thereby they can be coupled directly to the electrical apparatus they are to control.

The basic configuration of a C MOS comprises a pair of field-effect MOS transistors, respectively p-channel and n-channel ones, which are connected serially together to provide an inverter. Each MOS transistor comprises a substrate of a semiconductor material wherein source and drain zones are formed which are consistent and similarly doped and define a channel region overlaid by a layer of isolating oxide, the so-called gate oxide, covered by a conductive electrode effectively providing the gate for each transistor.

For a better understanding of the objects of this invention, it would seem appropriate to observe here that the drain zone of a conventional MOS transistor is basically homogeneous. However, in order to have such MOS devices withstand high voltages, in accordance with prior art techniques, a so-called Well pocket diffused at a low dopant concentration is formed in the semiconductor substrate using a dopant of an opposite type from the latter.

More specifically, that drain zone may be viewed conceptually as made up of three regions of like doping, namely:

the drain proper, which consists of a layer with a high dopant concentration;

the Well pocket, with a reduced dopant concentration; and

the lateral portion of the Well pocket facing toward the source and underlying the gate oxide of the transistor, this region being also doped at a low concentration.

Between the third-mentioned region and the drain, a so-called isolating layer wherein the concentration of the dopant falls at an intermediate level between that of the drain and that of the Well pocket. Further, the isolating layer is covered with an isolating oxide layer partly overlaid by the gate electrode of the transistor.

The MOS transistor just described has an isolating layer of increased thickness between the gate and the drain, and due to the reduced doping of the third-mentioned drain region, is subjected to lower strength electric fields than a homogeneous drain basic structure for a given voltage applied to the gate.

Consequently, it can withstand higher voltages.

Unfortunately, this prior approach, while substantially serving a purpose, has two serious drawbacks as outlined herein below.

The drain is not self-aligned to the gate electrode, which results in its occupying a larger area in the integrated circuit.

In addition, utilizing the Well pocket as a drain, besides increasing the overall size of the device, a high voltage transistor can only be formed on the starting substrate, which runs contrary to the need for forming unrestrictedly direct couplings to electrical apparatus external of the semiconductor device.

The technical problem underlying this invention is to provide an electronic device, in particular a silicon-gate field-effect MOS transistor, as specifically formed by a C MOS process, which has such structural and operational features as to enable its direct connection to an external electrical apparatus operating on a high input voltage, and can overcome the drawbacks mentioned herein above in connection with the prior art.

This problem is solved by an electronic device as indicated being characterized in that it comprises a so-called Well pocket with opposite doping from that of said substrate wherein said drain and source zones are formed, and a layer with an opposite doping from that of said pocket forming a side extension of said drain zone and being self-aligned to the gate oxide, said layer being doped at a lower concentration than said drain zone and covered with an isolating oxide layer.

The features and advantages of the semiconductor device according to the invention will become apparent from the following detailed description of an exemplary embodiment thereof, to be taken by way of illustration and not of limitation in conjunction with the accompanying drawings.

In the drawings:

Figure 1 is a sectional side view showing schematically the structure of an electronic semiconductor device according to the invention; and

Figures 2 to 4 are respective side sectional views showing schematically the structure of the device in Figure 1 at various stages of its manufacturing process.

With reference to the drawing views, the numeral 1 generally and schematically designates an electronic semiconductor device, in particular a p-channel, silicon-gate field-effect MOS transistor formed in accodance with this invention.

The device 1 comprises a substrate 2 of a semiconductor material which is very slightly doped with impurities of the "p" type and in which a so-called Well pocket 3 is formed which has an "n" type doping opposite from that of the substrate. Hereinafter, that pocket will be referred to a n-Well.

Formed above and within said n-Well pocket 3 are two zones of like p-type doping, intended to provide the source 4 and drain 5 of the transistor 1, as well as to delimit a so-called channel region 7 overlaid by a layer 6a of an isolating oxide, the so-called gate oxide, whose thickness determines the conduction threshold of the transistor 1. The layer 6a is covered with a metallic layer 6 providing the gate electrode of the transistor 1.

Advantageously according to the invention, the transistor 1 further comprises a layer 5a of opposite p-type doping from that of the n-Well pocket. This layer 5a is formed in the transistor 1 at a self-aligned location to the gate oxide 6a, and is linked to form a side extension of a portion 5b of the drain 5, the latter having p-type dopant at a higher concentration.

The above-mentioned layer 5a forms, therefore, an extension of the portion 5b of the drain 5 having a lower dopant concentration. Further, this layer 5a is covered with an isolating layer 10 of silicon oxide which is partly overlaid by a portion of the gate electrode 6.

Thus, the structure of the transistor 1 is asymmetrical, and the layer 5a, self-aligned to the gate oxide 6a, will be active as a low-doped extension of the drain 5.

A layer 11 of contact with the n-Well pocket 3 is formed laterally of the source 4.

Advantageously, in order to insulate the transistor 1 electrically, opposedly located insulating zones are also provided which are doped similar to the n-Well pocket 3 but at a higher concentration of n-type dopant. Such zones 8 are formed at the top peripheral margins of the n-Well pocket, laterally of the layer 11, associated with the source 4 and the portion 5b of the drain 5.

The insulating zones 8 are high conductivity ones, but their function is to raise the conduction threshold of parasitic transistors present in the structure of the transistor, thus providing what may be regarded to be an electrical insulation. Overlying each zone 8 is a layer 9 of a dielectric material, in particular silicon oxide referred to as field oxide, which is interrupted at the source 4 and the drain 5.

The structure of the transistor 1 is completed by a conventional top insulating layer 12 which is apertured at zones indicated at 13, having a predetermined surface area and being located at the source 4, drain 5, and layer 11 of contact with the n-Well pocket.

The apertures 13 in the insulating layer 12 are intended for electrical interlink metallic contacts 14. A final protective layer 15, referred to as the passivation layer, covers the device 1 and is apertured at selected zones for the metallic contacts 14.

The transistor device of this invention is formed using conventional procedures, quite familiar to a skilled one, in the manufacture of electronic semiconductor devices of the C MOS type. Understandably, when such procedures are used, it becomes impossible to provide devices in accodance with this invention which have truly complementary structures from the standpoint of the type of doping employed.

Accordingly, a transistor device according to the invention may be either formed as a p-channel or n-channel MOS transistor provided with an n-type or p-type Well pocket.

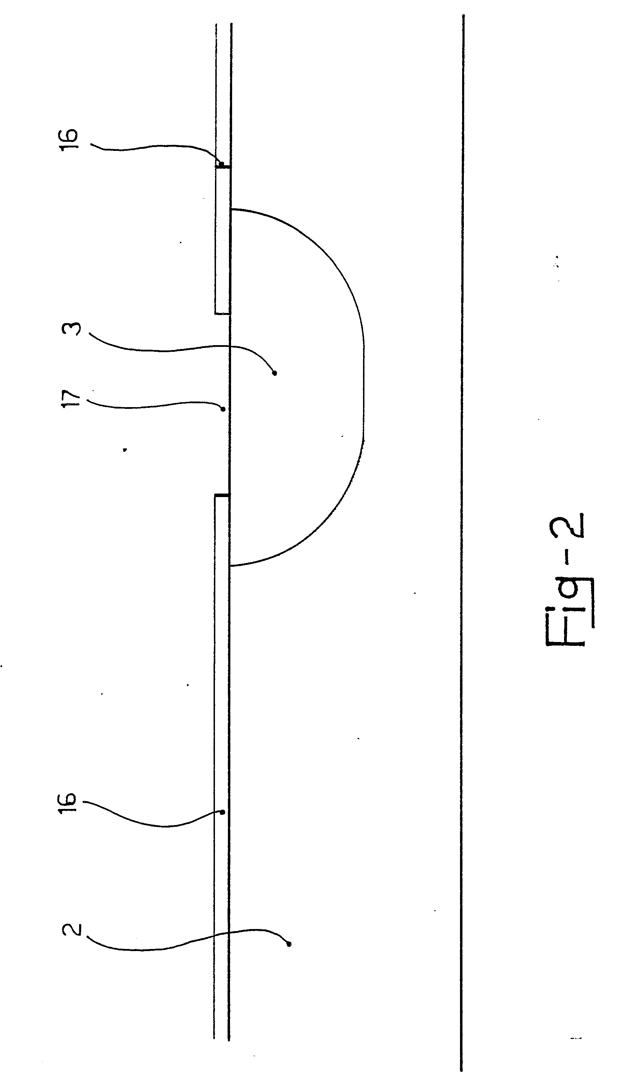

With specific reference to Figure 2, there is shown in schematic form the device 1 of this invention at an intermediate stage of its manufacturing process. The substrate 2 of a slightly doped semiconductor material with impurities of the p type, has been covered with an isolating layer 16 which is formed with a window 17 for implanting a dopant impurity of the n type therethrough, as diffused by means of an appropriate heat treatment until the n-Well pocket 3 is formed.

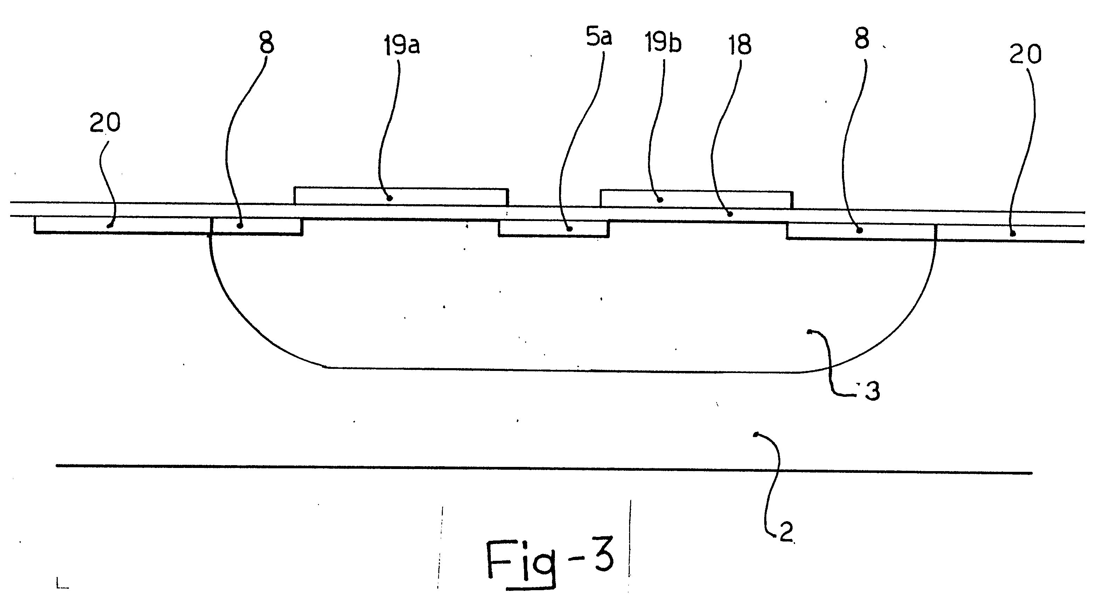

Shown in Figure 3 is a layer 18 of an isolating oxide overlying the substrate 2 and pocket 3. An additional layer, unaffected by oxidation, is applied over the preceding layer 18, and portions 19a and 19b are defined therein which are effective to delimit the areas intended to accommodate the active source, drain, and gate zones of the transistor 1.

Furthermore, using a process known as insulation masking process, there are injected into the substrate 2 and the n-Well pocket 3 impurities of both the p and n types to respectively form the layer 5a and p-type isolating layers, as well as the insulating zones 8 of the n type.

The isolating layer 5a. inserted between the portions 19a and 19b dedicated for the active zones of the transistor 1, will exhibit, therefore, an opposite doping from that of the pocket 3.

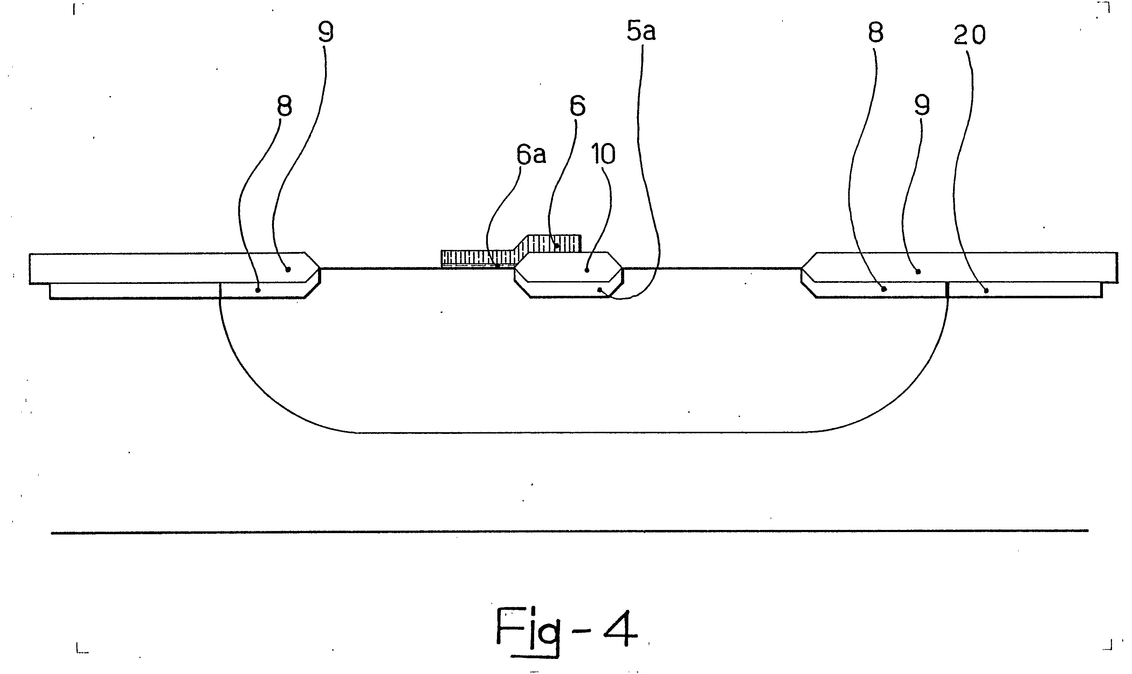

With reference to Figure 4, the outcome of a further step in the device 1 manufacturing process is shown. Over the insulating zones 8, there is formed an oxide, the so-called field oxide, layer 9, and the numeral 10 designates the oxide layer overlying the layer 5a.

Also shown in Figure 4 are the thin gate oxide layer 6a and the electrode 6 overlying it to partly cover the layer 10; it may be appreciated from that drawing figure that the layer 5a is self-aligned to the gate oxide.

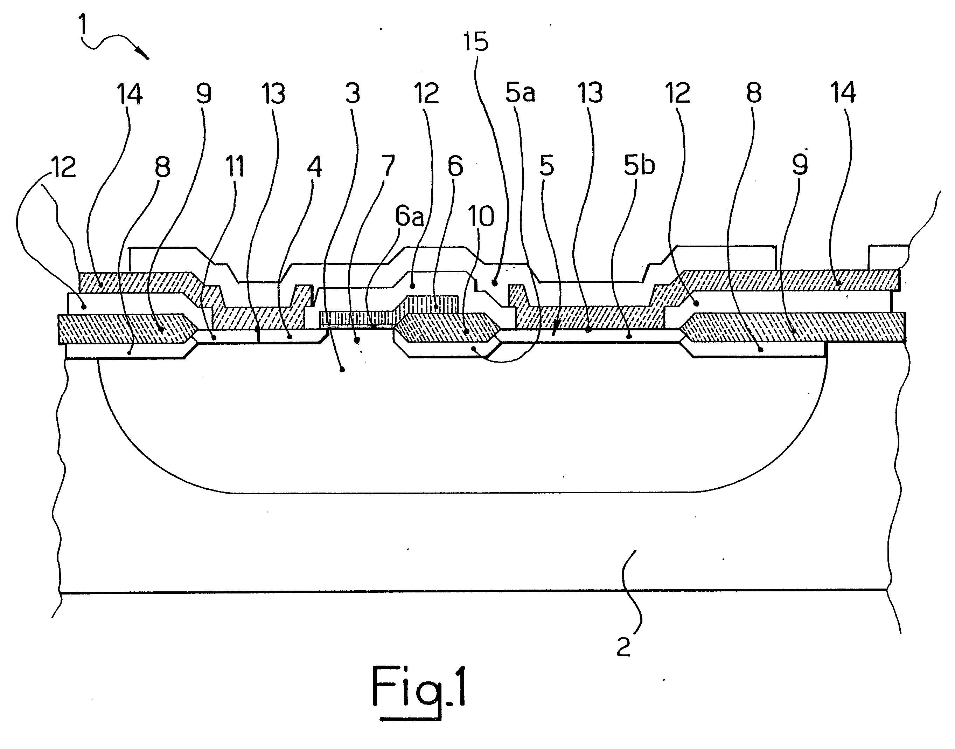

Further steps of the manufacturing process result in the source and drain zones being defined as well as the remaining regions of the transistor 1, as previously discussed with reference to Figure 1.

Accordingly, the device of this invention solves the technical problem, while affording a number of advantages, of which an outstanding one is that the transistor of this invention is fully isolated from the semiconductor substrate by the provision of the n-Well pocket associated above with the insulating zones delimiting both the source and drain of the transistor outwardly. This affords improved possibilities for linking to external electrical devices inasmuch as the transistor enclosed in the pocket can be suitably biased.

The transistor device of this invention operates at the normal voltage input for ordinary MOS transistors because its threashold voltage, which depends on the thickness 6a of the gate oxide, is unchanged relatively to the non-composite drain transistors forming most of the integrated circuit but unable to withstand other voltages.

Advantageously, however, laboratory tests carried out by the Applicant have shown that this device can be applied a much higher voltage than that applicable to the devices. thereby it can be coupled directly to an external apparatus operating on a different and higher input voltage from/than the voltage an integrated circuit can withstand.

A further advantage of the inventive device is its reduced surface area requirement in the integrated circuit. along with its compatibility with known processes for manufacturing C MOS circuits.

## Claims

1. An electronic semiconductor device (1), in particular a silicon-gate field-effect MOS transistor for high input voltages, and as formed by a C MOS process, of a type comprising a semiconductor silicon substrate (2) formed with two zones with like doping intended to provide the source (4) and drain (5) electrodes for said transistor and to delimit a channel region (7) overlaid by an oxide isolating layer (6a), commonly referred to as gate oxide, covered by a conductive layer (6) intended to provide the gate electrode for said transistor, characterized in that it comprises a so-called Well pocket (3) with opposite doping from that of said substrate (2) wherein said drain (5) and source (4) zones are formed, and a layer (5a) with an opposite doping from that of said pocket (3) forming a side extension of said drain (5) zone and being self-aligned to the gate oxide (6a), said layer (5a) being doped at a lower concentration than said drain (5) zone and covered with an isolatihg oxide layer (10).

2. A device according to Claim 1, characterized in that said isolating oxide layer (10) overlying said self-aligned layer (5a) is partly covered by a portion of the gate electrode (6)

3. A device according to Claim 1, characterized in that it comprises opposedly located so-called insulating zones (8) formed above and peripherally of said Well pocket (3), respectively laterally of the source (4) and drain (5) zones, having the same doping as said Well pocket (3) to electrically insulate said transistor.

4. A device according to Claim 3, characterized in that said insulating zones (8) are doped at a higher concentration than that of said Well pocket (3).

Fig.1

Fig-2

EP 0 309 828 A2

Fig-3

EP 0 309 828 A2

Fig-4

EP 0 309 828 A2